# EUROPEAN PATENT APPLICATION

(11) **EP 1 944 794 A1**
(43) Date of publication of application: **16.07.2008**
(21) Application number: 07113225.2
(22) Date of filing: 26.07.2007
(51) Int. Cl.: H01L 21/28, H01L 29/51

(54) **A method for controlled formation of a gate dielectric stack**

(30) Priority: 10.01.2007 US 879693 P; 29.06.2007 EP 07111486
(71) Applicant: Interuniversitair Microelektronica Centrum (IMEC), 3001 Leuven (BE); Taiwan Semiconductor Manufacturing Co., Ltd., 300-077 HsinChu (TW)
(72) Inventor: De Gendt, Stefan, Wijnegem B-2110 (BE); Schram, Tom, Rixensart B-1330 (BE); Adelmann, Christoph, Leuven B-3000 (BE); Chang, Shih-Hsun, Hsinchu 300 (TW); Van Elshocht, Sven, Leuven B-3001 (BE); Ragnarsson, Lars-Ake, Leuven B-3000 (BE)
(74) Representative: pronovem

(57) **Abstract**

The present invention relates to semiconductor process technology and devices.

In particular, the present invention relates to a method for forming a gate stack in a MOSFET device and the MOSFET device obtainable by said method.

## Description

### Field of the Invention

The present invention relates to semiconductor process technology and devices.

In particular, the present invention relates to a method for forming a gate stack in a MOSFET device and the MOSFET device obtainable by said method.

### Background

Ono et al. (Appl. Phys. Lett., 78, 1832 (2001)) have described that the rare earth (RE) elements, for example lanthanum, in contact with SiO₂ in an oxygen containing ambient react to form a silicate when heated to sufficiently high temperatures.

Depending on the nature of the element, the intensity of the silicate formation will vary. As a result of this, silicate formation may have different consequences.

One consequence is the consumption of the interface region between the rare earth element and the silicon-oxide resulting in a reduction of the equivalent oxide thickness (EOT) as observed by Lichtenwahlner et al. (J. Appl. Phys., 98, 024314 (2005)).

Another consequence is the shift of the threshold voltage towards lower values as reported by L. Pantisano et al. (Appl. Phys. Lett., 89, 113505 (2006)), when these rare earth materials are integrated in the gate stack as a cap layer of monolayer(s) thickness.

### Summary

The present invention relates to a method for forming a gate stack in a MOSFET device, comprising the steps of:
- forming, on a semiconductor substrate, at least one layer of a dielectric material, the upper layer comprising (or consisting of) a Si containing dielectric material (Si-CDM),
- depositing (immediately) on said Si-CDM, at least one rare earth oxide (REO) layer,
- depositing (immediately) on said REO layer, at least one layer of a suitable material for forming a metal gate electrode, and
- after having deposited said material suitable for forming a metal gate electrode on said REO layer, annealing (for obtaining a reaction, at least partially, between said Si-CDM and said REO layer), whereby a rare earth silicate (RES) layer is formed,
wherein there is no annealing step (resulting in RES formation) before having deposited said material suitable for forming a metal gate electrode on said REO layer.

In a method according to the invention, no annealing step is performed before the deposition of said metal gate.

Preferably, said annealing step is performed immediately after said metal gate deposition.

Preferably, said annealing step is a PDA step (post-deposition annealing step).

Said annealing step can be a RTA step (Rapid Thermal Anneal step).

Preferably (and alternatively), said annealing step can be performed after spacer definition. A method of the invention can further comprise, before the annealing step, the steps of polySi deposition, gate patterning and spacers formation.

Said annealing step can be a source/drain RTA step after spacer definition.

Said annealing step can comprise a source/drain RTA step and a PDA step, after spacer definition.

In a method according to the invention, said annealing step is preferably performed at a temperature higher than (about) 600°C, preferably comprised between (about) 600°C and (about) 1200°C, more preferably comprised between (about) 600°C and (about) 1000°C.

More preferably, said annealing step is performed at a temperature higher than (about) 800°C, preferably comprised between (about) 800°C and (about) 1200°C, more preferably comprised between (about) 800°C and (about) 1000°C.

Preferably, said REO and said Si-CDM are provided in a ratio REO:(REO + Si(CDM)) comprised between (about) 0.05 and (about) 0.4, more preferably between (about) 0.1 and (about) 0.4, even more preferably between (about) 0.2 and (about) 0.35, and even more preferably between (about) 0.2 and (about) 0.3.

In a method of the invention said at least one layer of a dielectric material preferably consists of said Si-CDM. In other words, preferably, in a method of the invention, at least one layer comprising (or consisting of) a Si-CDM is formed on said semiconductor substrate.

Said Si-CDM layer can comprise (or consist of) any suitable high-k material (i.e. any suitable material the dielectric constant of which is higher than the dielectric constant of SiO₂; i.e. k > k_{SiO2}).

Preferably, said at least one layer of Si-CDM comprises (or consists of) SiO₂.

In a method according to the invention, said at least one layer of Si-CDM can comprise or further comprise nitrogen. More particularly, said at least one layer of Si-CDM comprises (or consists of) SiON.

Preferably, said Si-CDM is formed or deposited by MOCVD, ALD, AVD or PVD deposition technique.

In a method of the invention said at least one layer of REO can comprise (or consist of) any of La, Y, Pr, Nd, Sm, Eu, Gd, Dy, Er, or Yb, or any combination of 2, 3 or more thereof. More particularly, said at least one layer of REO can comprise (or consist of) any of La-, Y-, Pr-, Nd-, Sm-, Eu-, Gd-, Dy-, Er-, or Yb-based oxides, or any combination of 2, 3 or more thereof.

Preferably, in a method of the invention said at least one layer of REO can comprise (or consist of) La and/or Dy based oxides.

More preferably, said REO layer comprises (or consists of) dysprosium oxide.

Preferably, said at least one REO layer is deposited by MOCVD, ALD, AVD or PVD deposition technique.

In a method of the invention said at least one layer of REO can result from the oxidation of a layer rare earth element.

In a method of the invention said at least one layer of Si-CDM and/or said at least one layer of REO can further comprise a modulator element, such as Al, Hf, or Sc.

Said modulator can be added to said REO layer for increasing the thermal stability of the layer.

In particular, said modulator element can be added to said Si-CDM layer and/or to said REO layer for enhancing or reducing the RES formation. More particularly, Hf and Sc hinder the RES formation; whereas Al is an enhancer of said RES formation.

Preferably, said REO layer comprises (or consists of) dysprosium scandate.

Preferably, said modulator is added to said REO layer in a ratio Modulator: (Modulator + RE) of about 50%.

Said modulator can be an enhancer element (such as Al), whereby the intermixing is enhanced. For example, Al can be added to the REO in a ratio Al:(Al+RE) smaller than (about) 75%.

Preferably, in a method according to the invention, said metal gate electrode comprises (or consists of) W, Ta, Ti, Ru, Pt and/or Mo, preferably TiN, TaN and/or Ru.

Preferably, in a method according to the invention, said substrate comprises (or consists of) a Ge, SiGe, GaAs, and/or InP layer.

The invention relates also to a method for reducing the EOT of a gate stack in a MOSFET device, by capping a Si containing dielectric layer with a REO and annealing (forming a RES layer) after depositing a metal gate electrode.

Said method for reducing the EOT of a gate stack in a MOSFET device can comprise the same steps as a method of the invention for forming a gate stack in a MOSFET device.

In particular, the EOT can be reduced of at least 0.1 nm EOT when the ratio REO: (REO + Si(CDM)) is comprised between (about) 0.05 and (about) 0.4, more particularly between (about) 0.1 and (about) 0.4, even more particularly between (about) 0.2 and (about) 0.35, and even more particularly between (about) 0.2 and (about) 0.3.

Alternatively, in a second embodiment, instead of the REO formation, a method of the invention can be carried out with the deposition of a layer of a rare earth element (RE element), the oxidation of which being prevented. More particularly, the RE layer can be deposited in-situ, i.e. with no vacuum break between said RE deposition and the metal gate deposition.

In that embodiment, the RES results from the annealing of said Si-CDM layer and said RE layer.

More particularly, a method for forming a gate stack in a MOSFET device, according to said second embodiment can comprise the steps of:
- forming, on a semiconductor substrate, at least one layer of a dielectric material, the upper layer comprising a Si containing dielectric material (Si-CDM), preferably SiO₂ or SiON,
- depositing on said Si-CDM, at least one rare earth (RE) layer,
- depositing on said RE layer, at least one layer of a suitable material for forming a metal gate electrode, and
- after having deposited said material suitable for forming a metal gate electrode on said RE layer, annealing (for obtaining a reaction, at least partially, between said Si-CDM and said RE layer), whereby a rare earth silicate (RES) layer is formed,
wherein oxidation of said RE layer is prevented (preferably by maintaining the vacuum till said layer of a suitable material for forming a metal gate electrode have been deposited), and
wherein there is no annealing step before having deposited said material suitable for forming a metal gate electrode on said RE layer.

The other conditions and parameters used herein also apply to that embodiment.

The method of the invention can also be carried out for forming capacitors such as metal-insulator-metal capacitors wherein the dielectric stack constitutes the dielectric part of such capacitor.

More particularly, a method of the invention for forming capacitors, such as metal-insulator-metal capacitors, comprises the steps of:
- forming, on a material suitable for forming an electrode, at least one layer comprising (or consisting of) a Si-CDM,
- depositing (immediately) on said Si-CDM, at least one REO or RE layer,
- depositing (immediately) on said REO or RE layer, at least one layer of a material suitable for forming an electrode, and
- after having deposited said material suitable for forming an electrode on said REO or RE layer, annealing (for obtaining a reaction, at least partially, between said Si-CDM and said REO or RE layer), whereby a rare earth silicate (RES) layer is formed,
wherein there is no annealing step (resulting in RES formation) before having deposited said material suitable for forming an electrode on said REO or RE layer.

Another object of the present invention is a semiconductor device obtainable by a method according to the invention.

In particular, the present invention also relates to a capacitor, such as metal-insulator-metal capacitor.

And more particularly, the present invention also relates to a MOSFET device obtainable by a method according to the invention.

In particular, a MOSFET device according to the invention comprises:
- a semiconductor substrate,
- a gate dielectric comprising (or consisting of) at least one layer of a dielectric material, the upper layer comprising (or consisting of) a Si-CDM,
- upon said Si-CDM, a RES layer, and
- upon said RES layer, a metal gate electrode,
wherein said RES layer results from the annealing of said Si containing dielectric material and said REO or RE layer, said annealing being performed only after having deposited said metal gate electrode.

A MOSFET device according to the invention can further comprise unreacted REO or unreacted RE. A REO or RE layer can remain between said RES and said metal gate electrode.

A MOSFET device according to the invention can further comprise a polySi layer on said metal gate electrode.

Preferably, said at least one layer of dielectric material consists of said Si-CDM.

Preferably, said at least one layer of Si-CDM comprises SiO₂, SiON, HfSiO, or HfSiON.

More preferably, said at least one layer of Si-CDM consists of SiO₂, SiON, HfSiO, or HfSiON.

Preferably, said REO or RE layer comprises (or consists of) any of La, Y, Pr, Nd, Sm, Eu, Gd, Dy, Er, Yb or any combination of 2, 3 or more thereof.

More preferably, said REO layer comprises (or consists of) any of La-, Y-, Pr-, Nd-, Sm-, Eu-, Gd-, Dy-, Er-, and Yb- based oxides or any combination of 2, 3 or more thereof. Even more preferably, said REO layer comprises (or consists of) any of La and/or Dy based oxides, and more particularly dysprosium oxide, or dysprosium scandate.

Preferably, said metal gate electrode comprises (or consists of) W, Ti, Ta, Pt, Ru and/or Mo, preferably TiN, TaN and/or Ru.

Preferably, said substrate comprises (or consists of) a Ge, SiGe, GaAs, and/or InP layer.

### Brief Description of the Figures

Figure 1 (a) shows the physical thickness variation of the as deposited gate dielectrics upon anneal at different temperatures.

Figure 1 (b) shows the thickness variation of the as deposited ALD La₂0₃ upon different anneal steps approximately from 600°C to 1000°C.

Figure 2 shows the normalized thickness increase (t_{annealed} - t_{dep})/t_{dep} for DyScOₓ layers annealed in O₂ (•: circle) or N₂ (A: triangle), where t_{annealed} is the layer thickness after a thermal anneal at about 1000°C and t_{dep} is the as-deposited thickness of the layer.

Figure 3 shows the normalized thickness increase for an about 10 nm DyScOₓ layer after different thermal treatments (temperature and time).

Figure 4. shows the normalized thickness increase (t_{annealed} - t_{dep})/t_{dep} (•: circle) and absolute thickness increase (A: triangle) after 1000°C anneal for a DyScOx layer as function of the as-deposited thickness.

Figure 5 shows the normalized thickness increase (t_{annealed} - t_{dep})/t_{dep} after a 1000°C anneal for DyScOx layers as function of the anneal time: Dy-rich (about 75%Dy) (•: circle); Sc-rich (about 25%Dy) (■: square) .

Figure 6 shows the relative thickness increase (%) as function of the Dy concentration (%) for two different compounds: DyHfOx (■: square) and DyScOx (•: circle).

Figure 7 presents the threshold voltage (Vt) shift for Dy-based and Sc-based oxides and a combination thereof.

In Figure 8 (a), as a demonstration, a SiON dielectric film of 2 nm thickness has been capped by 1 nm of Dy₂O₃ and capped with a TaN metal electrode. After application of a junction activation thermal budget (1030°C), a gate stack EOT has been extracted, clearly less than the original 2 nm SiON. A reduction in EOT from about 1.8 nm down to 1.3 nm EOT has been observed, as well as a reduction in Vt as shown in Figure 8 (b).

Figure 9 shows the effects of Dy₂O₃ cap thicknesses on the EOT of SiON/Dy₂O₃/TaN.

Figure 10 shows the EOT and eWF of SiO(N)/Dy₂O₃/TaN as a function of Dy₂O₃/ (Dy₂O₃+SiO (N)) thickness ratio.

Figure 11 shows hte EOT and eWF of SiO(N)/Dy₂O₃/TaN with various thermal budgets and annealing sequences.

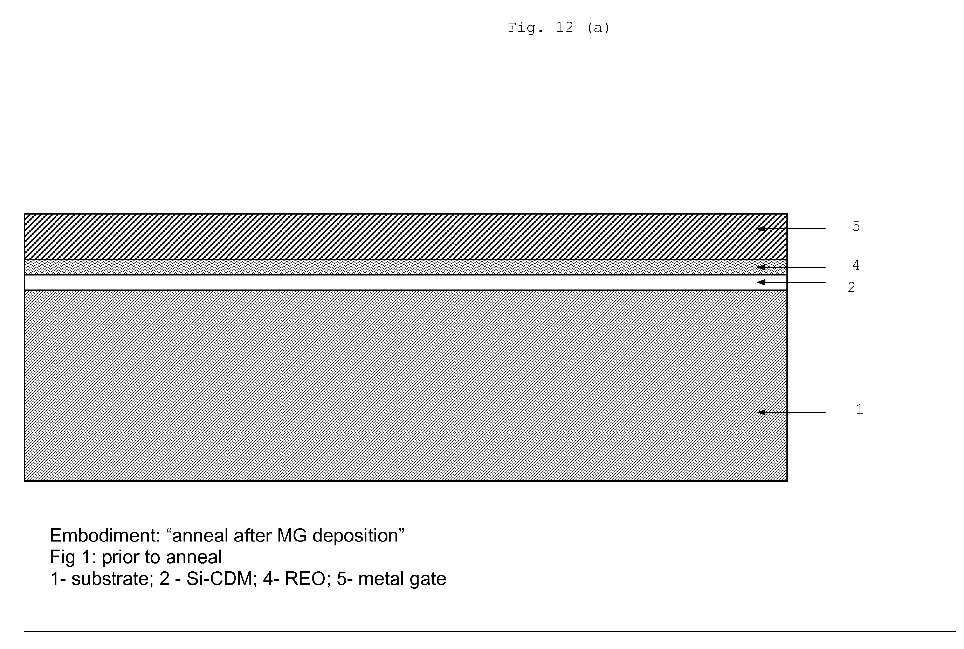

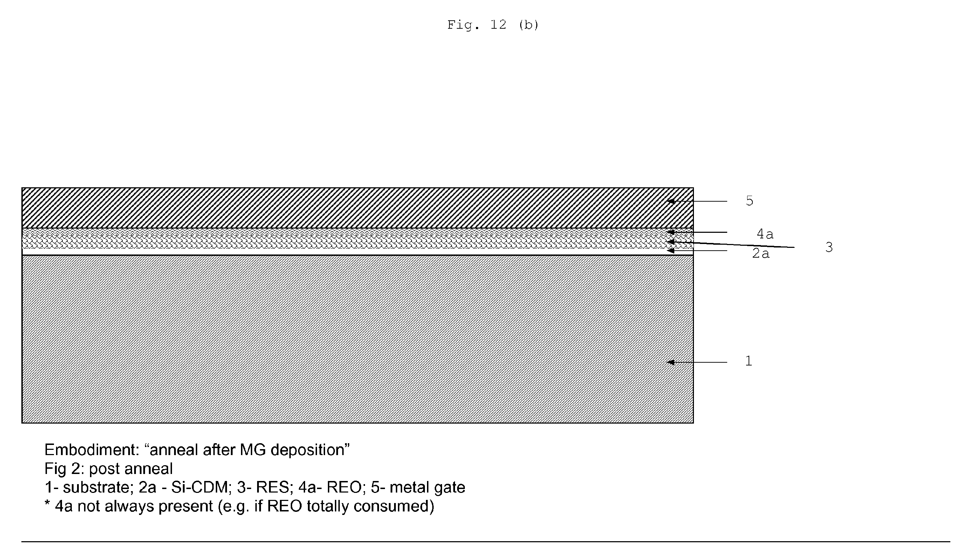

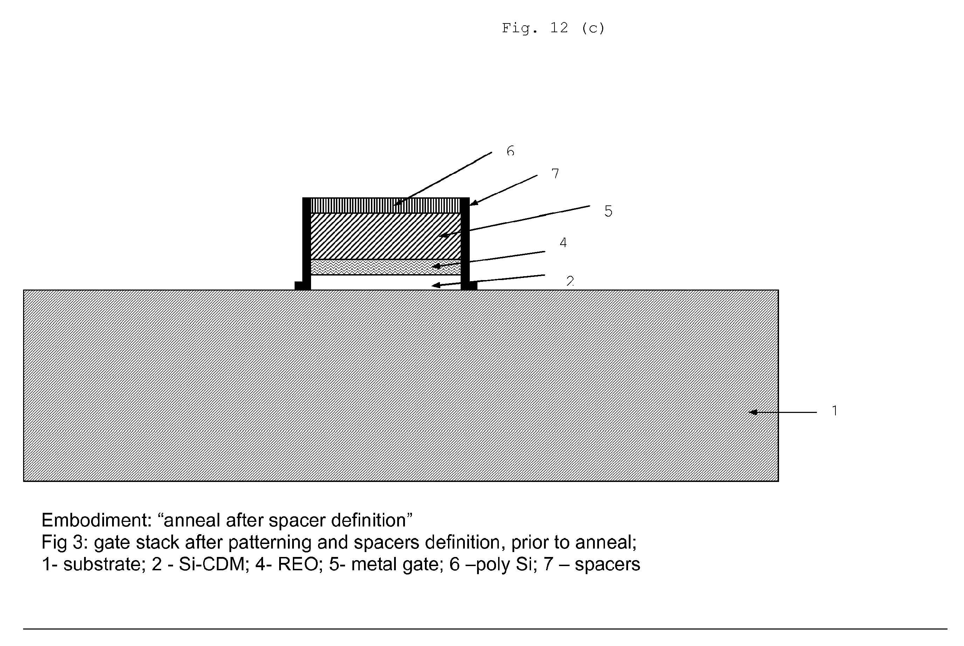

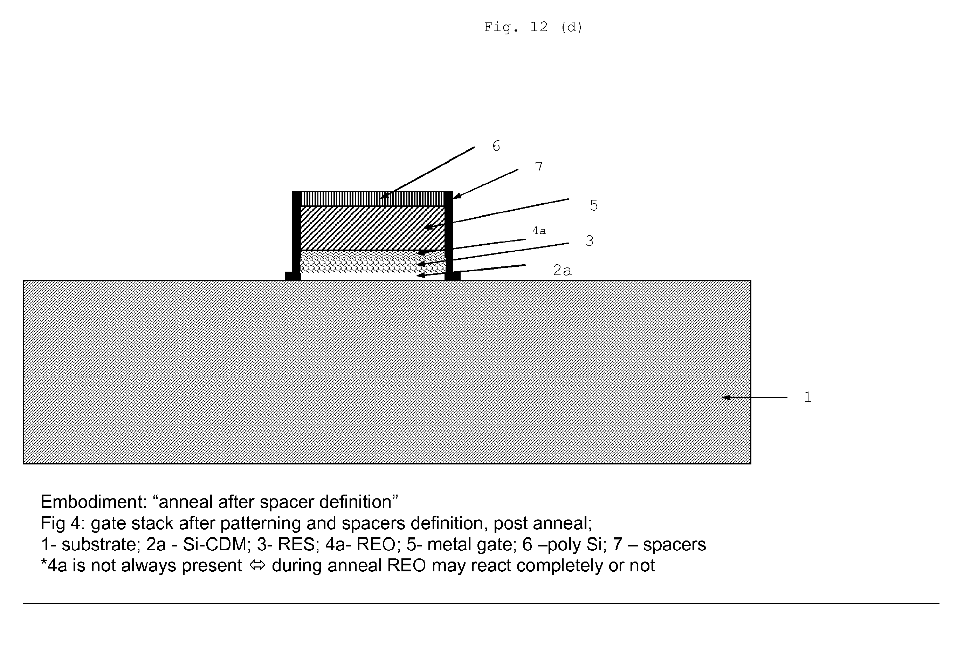

Figure 12 illustrates different aspects of a method of the invention:
(a) before a PDA annealing, the stack of layers comprises the substrate (1), the Si-CDM (2, 2a), the REO (4) and the metal gate (5);
(b) after the PDA annealing of the stack of layers as illustrated in (a), the resulting stack of layers comprises the substrate (1), the Si-CDM (2a), the RES (3), possibly remaining REO (4a), and the metal gate (5);
(c) before the annealing step, the stack of layers comprises the substrate (1), the Si-CDM (2, 2a), the REO (4), the metal gate (5), the polySi (6) and the spacers (7); and
(d) after said annealing step (performed after spacers definition), the resulting stack of layers comprises the substrate (1), the Si-CDM (2a), the RES (3), possibly remaining REO (4a), the metal gate (5), the polySi (6) and the spacers (7).

### Description

The present invention provides a method for forming a gate stack in a MOSFET device, comprising the steps of:
- forming, on a semiconductor substrate, at least one layer of a dielectric material (2, 2a), the upper layer comprising (or consisting of) a Si-CDM,
- depositing (preferably immediately) on said Si-CDM, at least one rare earth oxide (REO) layer (4),
- depositing (preferably immediately) on said REO layer (4), at least one layer of a suitable material for forming a metal gate electrode (5), and
- after having deposited said material suitable for forming a metal gate electrode on said REO layer, annealing (for obtaining a reaction, at least partially, between said Si-CDM and said REO layer), whereby a rare earth silicate (RES) layer is formed,
wherein there is no annealing step (resulting in RES formation) before having deposited said material suitable for forming a metal gate electrode on said REO layer.

The present invention is based on the surprising discovery that the best results in terms of EOT reduction (Equivalent Oxide Thickness reduction) and eWF shift (effective work function shift) are obtained when the anneal (for said RES formation) step takes place only after the metal gate electrode has been deposited on said REO.

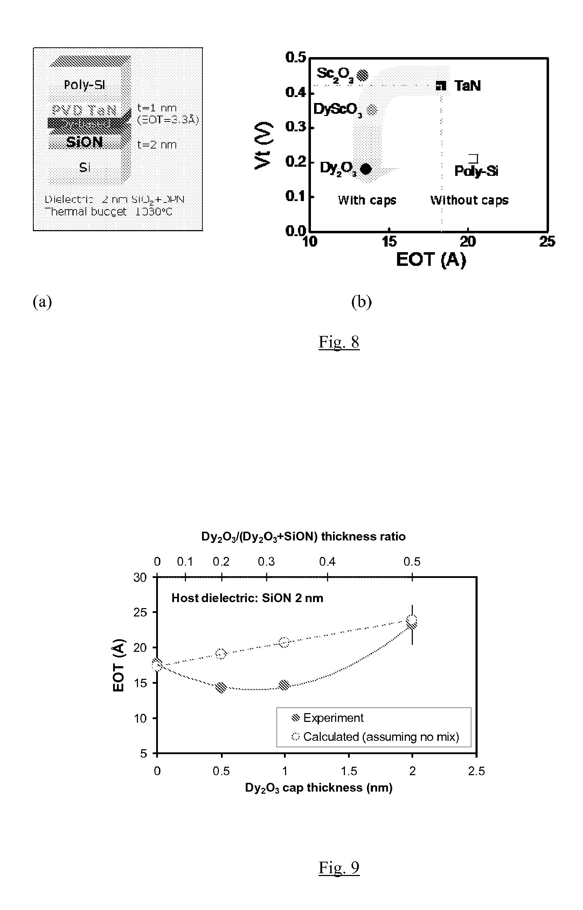

The present invention is further based on the surprising discovery that there is an optimum ratio REO/(REO +SiCDM) for which the EOT is the lowest (see fig. 9). Indeed, a second unexpected observation was the increase of the EOT when departing away from that optimum REO/(REO +Si-CDM) ratio.

Fig. 9 shows the effect of Dy₂O₃ thickness on the EOT of SiON/Dy₂O₃ stacks with a fixed SiON thickness (2 nm).

If assuming Dy₂O₃ and SiON do not intermix, the calculated EOT (open circles) increases with the Dy₂O₃ cap thickness.

However, the experiment result shows that the EOT actually decreases from 1.8 nm to 1.4 nm (18 to 14 Å) when the SiON is capped with 0.5- and 1-nm Dy₂O₃.

However, when the Dy₂O₃ thickness increases to 2 nm, the EOT increases again, agreeing with the calculated value assuming no mixing.

This indicates that the intermixing between Dy₂O₃ and SiON only occurs at certain Dy₂O₃/(Dy₂O₃+SiO₂) thickness ratio. The optimal Dy₂O₃/(Dy₂O₃+SiO₂) thickness ratio for minimal EOT is comprised between 0.2 and 0.4.

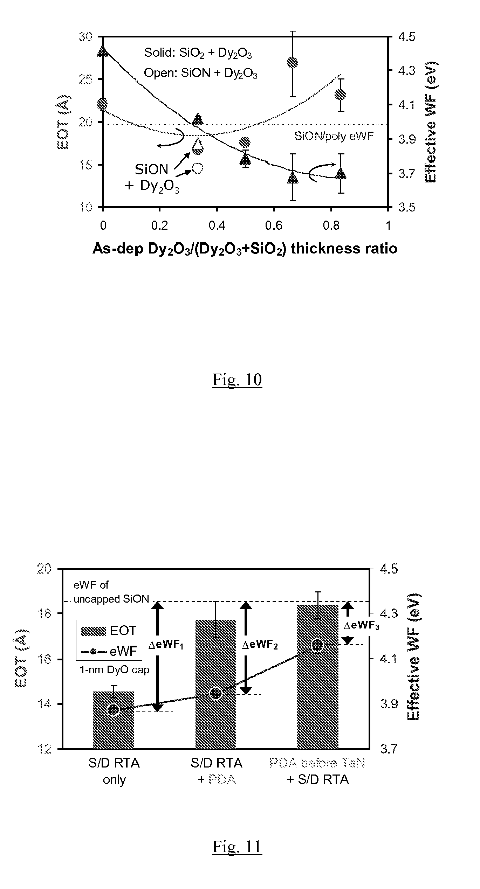

Fig. 10 shows the effect of Dy₂O₃/(Dy₂O₃+SiO₂) thickness ratio thickness on the EOT of SiON/Dy₂O₃ stacks with a fixed total Dy₂O₃+SiO₂ thickness (3 nm).

The EOT of the SiO₂/Dy₂O₃ stack is a function of the Dy₂O₃/(Dy₂O₃+SiO₂) thickness ratio.

The smallest EOT is obtained at a ratio comprised between about 0.3 and about 0.4, corresponding to an EOT reduction of 0.5 nm (5 Å) as compared to the uncapped SiO₂.

However, with the Dy₂O₃/(Dy₂O₃+SiO₂) thickness ratios of 0.6 and above, the EOT increases and exceeds that of the uncapped SiO₂.

Unlike EOT, which exhibits a parabolic relationship with the Dy₂O₃/(Dy₂O₃+SiO₂) thickness ratio, the effective work function (eWF) is inversely proportional to the ratio.

The eWF decreases from 4.4 to 3.7 eV as the Dy₂O₃/(Dy₂O₃+SiO₂) thickness ratio increases from 0 to 0.7, and stabilizes at 3.7 eV with a ratio higher than 0.7.

The optimal Dy₂O₃/ (Dy₂O₃+SiO₂) thickness ratio is about 0.3 where the EOT reduction is maximized and the eWF is comparable to that of the SiON/poly reference (4.0 eV).

Fig. 10 also shows that when nitrogen is added in SiO₂, the EOT and eWF decrease by 0.2 nm (2 Å) and 150 mV, respectively, as compared to the SiO₂/Dy₂O₃ stack at the same the Dy₂O₃/(Dy₂O₃+SiO₂) thickness ratio. The EOT decrease may result from an increased dielectric constant or enhanced Dy₂O₃-SiO(N) intermixing due to the nitrogen incorporation.

The eWF decrease may result from the positive charges induced by the nitrogen incorporation which was also seen on the HfSiO(N)/Ta₂C stack.

Fig. 11 shows the EOT and the eWF of Dy₂O₃-capped SiON from various thermal budgets and annealing sequences.

Besides the standard activation anneal ("S/D RTA") at 1030°C, an additional post-deposition anneal (PDA) at 1050°C was performed either after the S/D RTA ("S/D RTAS + PDA") or before the metal gate deposition ("PDA before TaN + S/D RTA").

By comparing "S/D RTA only" and "S/D RTAS + PDA," it can be shown that an additional PDA increases the eWF only slightly, rendering the eWF shift (ΔeWF₂) slightly smaller.

However, when the PDA is performed on the as-deposited Dy₂O₃ before metal gate deposition ("PDA before TaN + S/D RTA"), the eWF shift (ΔeWF₃) decreases substantially by 220 meV.

This shows that to achieve the maximal eWF tuning, the (high-temperature) anneal needs to be performed after the Dy₂O₃ cap is covered/enclosed, in this example, by the metal gate, poly electrode, and spacer.

According to a preferred embodiment, a method of the invention for forming a gate stack in a MOSFET device, comprises the steps of:
- forming, on a semiconductor substrate, one layer of SiO₂ or one layer of SiON,
- forming or depositing on said SiO₂ or said SiON, one dysprosium scandate layer, or one lanthanum oxide layer, or preferably one dysprosium oxide layer,
- depositing on the REO layer, at least one layer of a suitable material for forming a metal gate electrode, preferably a TaN layer, and
- after having deposited said material suitable for forming a metal gate electrode on said REO layer, annealing (for obtaining a reaction, at least partial, between said SiO₂ or SiON layer and said REO layer, whereby a rare earth silicate (RES) layer is formed,
wherein there is no annealing step before having deposited said material suitable for forming a metal gate electrode on said REO layer.

Depending on the substrate, said annealing step is performed at a temperature preferably comprised between 600°C and 1200°C, more preferably comprised between 600°C and 1000°C.

Preferably, said REO and said SiO₂ (or said SiON) are provided in a ratio REO: (REO + SiO₂) comprised between 0.1 and 0.4, more preferably between 0.2 and 0.4, and even more preferably between 0.2 and 0.3.

Said REO layer can be formed or deposited by MOCVD, ALD, AVD or PVD deposition technique.

Said SiO₂ or SiON layer can be formed or deposited by MOCVD, ALD, AVD or PVD deposition technique.

Said SiO₂ or SiON layer can further comprise Sc, Hf or Al.

Alternatively, said REO layer can further comprise Sc, Hf or Al.

Possibly, both REO layer and SiO₂ (or SiON) layer can further comprise Sc, Hf or Al.

In a preferred method of the invention, said metal gate electrode can comprise (or consist of) W, Ta, Ti, Ru, Pt and/or Mo, more particularly can comprise (or consist of) TiN, TaN and/or Ru.

In a preferred method of the invention, said substrate can comprise (or consist of) a Ge, SiGe, GaAs, and/or InP layer.

Said annealing step can be a post-deposition anneal or a RTA step.

An object of the present invention is also a semiconductor device, more particularly a MOSFET device obtainable by a preferred method of the invention.

In particular, a preferred MOSFET device of the invention comprises:
- a semiconductor substrate,
- a gate dielectric comprising a SiO₂ or a SiON layer,
- upon and contacting said SiO₂ or SiON layer, a rare earth silicate (RES) layer comprising Dy and/or La, and
- a metal gate electrode.

Said RES layer results from the annealing of the SiO₂ or SiON layer and the REO layer (comprising Dy and/or La) that are deposited (or formed) upon said substrate, said annealing being performed only after having deposited said metal gate electrode.

Said SiO₂ or SiON layer can further comprise Sc, Hf or Al.

Alternatively, said RES layer can further comprise Sc, Hf or Al.

Possibly, both RES layer and SiO₂ (or SiON) layer can further comprise Sc, Hf or Al.

Said metal gate electrode can comprise (or consist of) W, Ti, Ta, Pt, Ru and/or Mo, preferably can comprise (or consist of) TiN, TaN and/or Ru.

Said substrate can comprise (or consist of) a Ge, SiGe, GaAs, and/or InP layer.

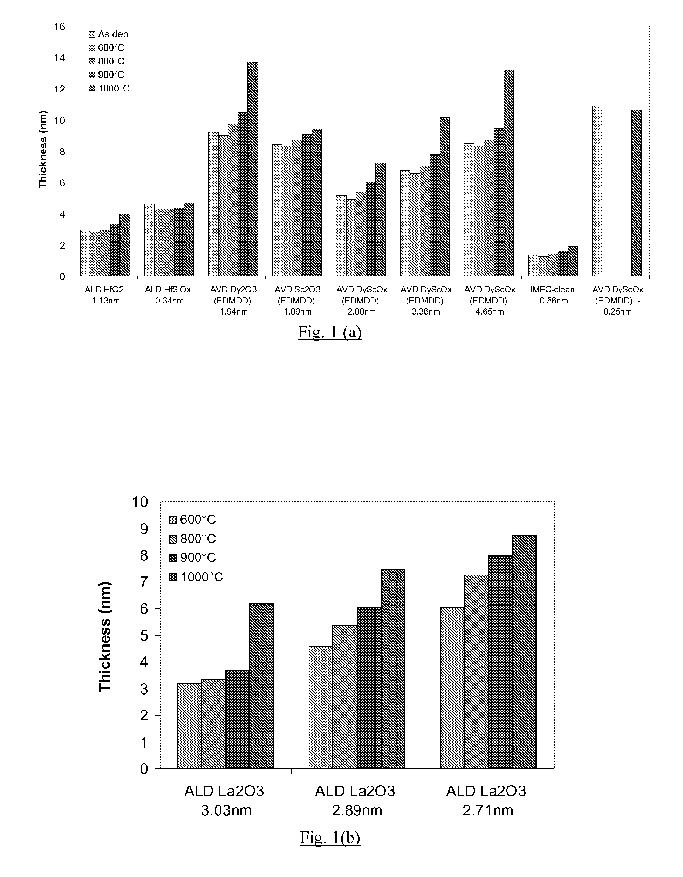

Figure 1 (a) shows the physical thickness variation of the as deposited gate dielectrics upon anneal at different temperatures. On the X-axis are the ellipsometrically measured film thicknesses for the various gate dielectrics. Various deposition techniques like Atomic layer Deposition (ALD) and Atomic Vapor Deposition (AVD) have been employed.

The films have been deposited on an interfacial SiO₂ₓ silicon oxide like interface, which is not distinguishable from the ellipsometer result.

The deposited bi-layer film stack has been annealed at temperatures approximately between 600°C and 1000°C in O₂, the later to explicitly stimulate the film thickness increase.

The bar graph for IMEC-clean indicates the silicon substrate oxidation as function of anneal treatment studied (reference). The IMEC-clean is a wet cleaning sequence comprising the steps of organic removal with SOM (Sulphuric acid- Ozone mixture), followed by APM (ammonium peroxide) cleaning and diluted HF/HC1 with DI (deionized) water rinses in between and Marangoni drying at the end. This substrate only received a clean thereby forming a chemical oxide.

It can be seen that the thickness increase/layer reaction is thermally activated, the larger the thermal budget the larger the physical thickness, and fully deploying at temperatures of approximately 1000°C or above. However, the degree of reactivity, i.e. the dependency of physical thickness on thermal budget, clearly depends on the species involved, with Dy (and La, see Fig 1(b)) reacting more substantial than Sc (or even Si) containing films. Moreover, the reactivity of the Dy containing films can be modulated with Sc addition.

Figure 1 (b) shows the thickness variation of the as deposited ALD La₂O₃ upon different anneal steps approximately from 600°C to 1000°C. Similar as for Dy, also for La a clear reactivity and hence physical thickness increase can be observed upon thermal annealing. However, as can be seen from Figure 1 (b), La₂O₃ shows a different behavior compared to Dy:
- a reactivity at lower temperatures (about 800°C),
- moreover, the thickness increase does not depend on the as deposited thickness of the La₂O₃ layers.

This shows that the (rare earth) element used is one of the parameters that assist in controlling the dielectric properties of the final gate dielectric layer outcome at the end of the process.

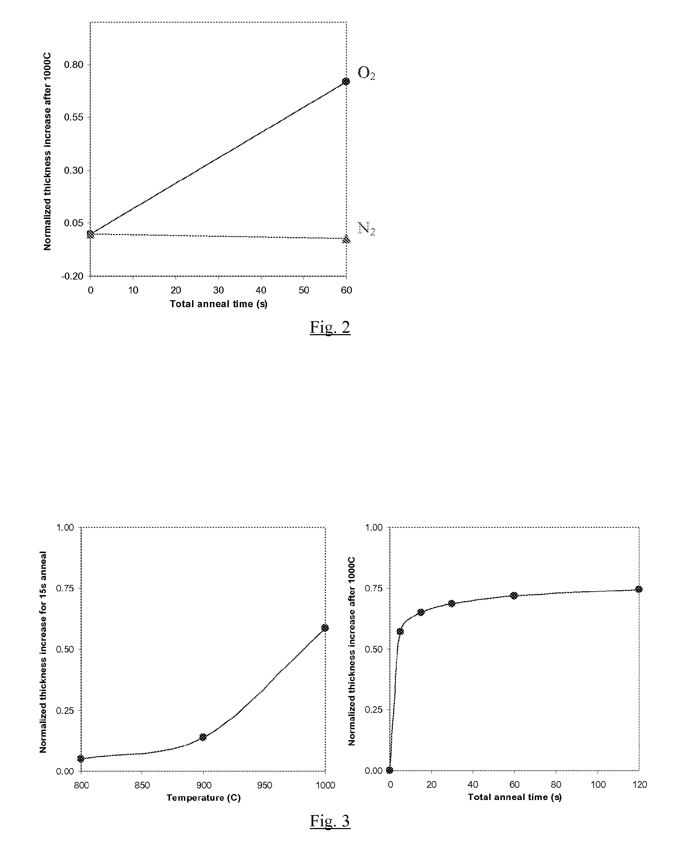

When annealing a rare earth oxide (REO) layer or stack of layers deposited on top of silicon oxide , silicate formation can be witnessed for example as:
a) in the absence of an additional oxygen supply: a density decrease of the rare earth (RE) oxide layer because of intermixing of the RE oxide with silicon oxide , but without any significant thickness change of the total dielectric stack, as shown in Figure 2 (N₂ atmosphere);
b) in the presence of an oxygen source: as a thickness increase caused by a volume expansion due to the incorporation of Si or SiO₂, at the reaction front between rare earth film and the silicon oxide film in addition to the regrown or the already present SiO₂ before deposition as shown in Figure 2 (O₂ atmosphere).

Figure 2 shows the normalized thickness increase (t_{annealed} - t_{dep})/t_{dep} for DyScOₓ layers annealed in O₂ (•: circle) or N₂ (A: triangle), where t_{annealed} is the layer thickness after a thermal anneal at about 1000°C and t_{dep} is the as-deposited thickness of the layer.

Besides the ambient used during the anneal step, the silicate formation is function of the thermal budget applied, i.e. depends on time as well as temperature, as shown in Figure 3.

Figure 3 shows the normalized thickness increase for an about 10 nm DyScOₓ layer after different thermal treatments (temperature and time).

For the example of DyScOₓ, it is clear that the thickness increases more as temperature goes up, especially at temperatures exceeding about 900°C. It can also be seen that the initial silicate formation occurs very fast before stabilizing to an equilibrium value that can be interpreted as the maximum solubility of SiO₂ in DyScOx.

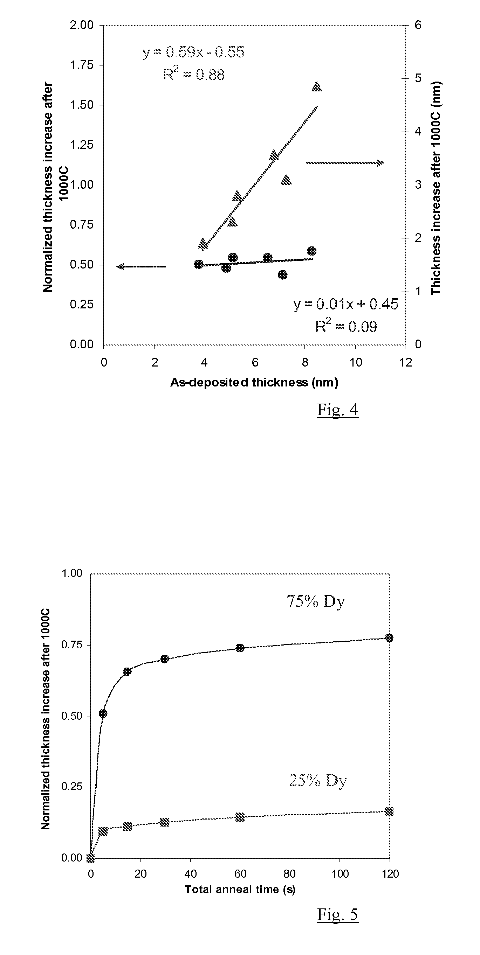

Figure 4. shows the normalized thickness increase (t_{annealed} - t_{dep})/t_{dep} (•: circle) and absolute thickness increase (A: triangle) after 1000°C anneal for a DyScOx layer as function of the as-deposited thickness.

Figure 5 shows the normalized thickness increase (t_{annealed} - t_{dep})/t_{dep} after a 1000°C anneal for DyScOx layers as function of the anneal time: Dy-rich (about 75%Dy) (•: circle); Sc-rich (about 25%Dy) (■: square).

The maximum amount of SiO₂ that can be incorporated in the gate dielectric film stack will depend on the amount of rare earth material present (see also Figure 1 (a)). This is evidenced by:
a) the relation between the relative thickness increase and the thickness of the as-deposited rare earth oxide, i.e. the thicker the as-deposited layer, the more SiO₂ can be incorporated as shown in Figure 4. When considering the relative thickness increase it is clear that the system strives to a certain equilibrium composition, based on the graph below. This equilibrium composition is approximately about 2:1 RE:SiO₂. This ratio is determined by the composition of the rare earth layer (see below Figure 4 for DyScOx) and not by the physical thickness of the layer.
b) the different behavior of ~10-nm thick DyScOx layers with different composition. The relative thickness increase clearly depends on the composition of the DyScOx layer, where the Dy-rich layer, i.e. the layer that contains the most amount of Dy demonstrates a much larger thickness increase as compared to the Sc-rich layer as shown in Figure 5. This again demonstrates that the amount of SiO₂ that can be incorporated in the stack depends on the amount of Dy present.

The behavior described above corresponds to an unlimited supply of oxygen, i.e. where all anneal treatments in a process flow for manufacturing a semiconductor device comprising a gate stack according to the present invention are done in an oxygen ambient. In that case the system will evolve to a condition where the maximum amount of SiO₂ can be incorporated.

An influence is also seen from the element that is incorporated (co-deposited) in the gate dielectric stack.

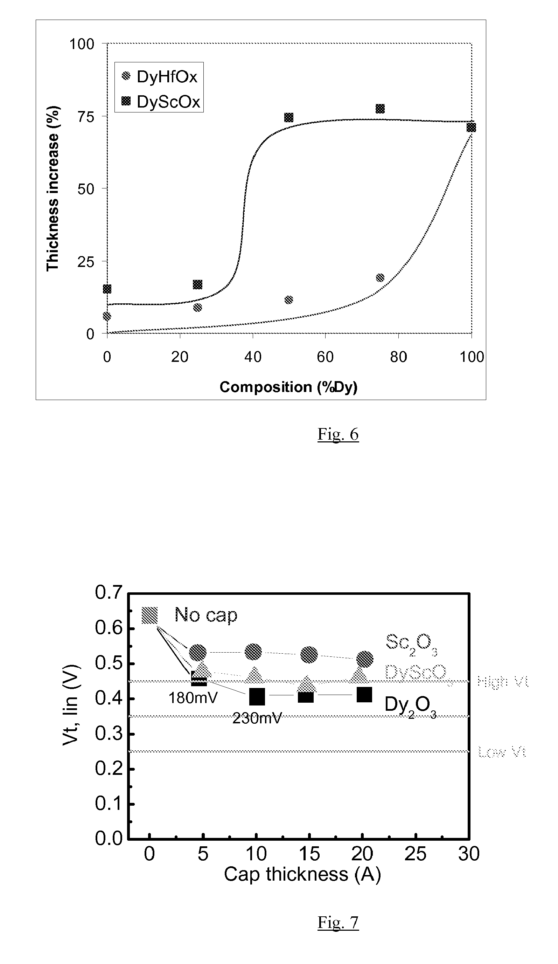

Figure 6 shows the relative thickness increase (%) as function of the Dy concentration (%) for two different compounds: DyHfOx (■: square) and DyScOx (•: circle).

Comparing for example DyScOx with DyHfOx layers with varying composition, it is clear that both stacks behave differently as shown in Figure 6.

Whereas DyScOₓ layers rather behave as Dy₂O₃ layers (extensive silicate formation) except for the more Sc-rich layers, incorporation of Hf is clearly seen to limit the silicate formation (less thickness increase since less SiO₂ incorporation) up to the very Dy-rich DyHfOx layers.

The behavior described above corresponds to an unlimited supply of oxygen.

For the case where the anneal is performed without additional oxygen supply, e.g. anneal in N₂ or for a layer covered (capped) with an oxygen impermeable layer, silicate formation can only occur by mixing of the RE oxide with the SiO₂ present in the underlying layer. This mixing results in a drop of the density of the RE oxide. This density drop is proportional to the ratio of RE/SiO₂. Once all SiO₂ has been able to react, the system will reach a stable state. The state is stable as long as the system is closed, i.e. the gate dielectric is covered (capped) with a metal gate layer on top preventing exposure of the gate dielectric to oxygen and/or no further thermal budgets are applied in an oxygen-containing ambient with a magnitude above the threshold for a given gate dielectric layer formed.

To achieve high performances, the ideal metal gate needs a tunable work function with process conditions "similar" to classical silicon technologies. This implicitly suggests gaining control of the interface polarization between the metal and the dielectric to engineer the gate work function.

In that respect, the introduction of controlled chemical "impurities" at the dielectric/metal interface is a promising approach. The impact of a low concentration [about 10¹³ atm/cm²] of electropositive elements (such as Rb, Sr, Y, Cs, etc.) at the SiO₂/TiN and HfO₂/TiN interfaces has been modeled using a simple approach based on the derivation of the atomic partial charges present at the interface [Smith, J.Chem.Edu, vol 67, p 559, 1990] and on the potential they generate (within a punctual charge treatment). The models revealed that the work function of TiN could be shifted up to about 0.35 eV, depending on both the nature of the chemical elements and the oxide considered.

Bringing this to practice means that - as a function of thermal budget applied - the interface region between gate electrode and gate dielectric (or gate dielectric stack) can be modified such that an appropriate work function is achieved. Experimental evidence has been gained for this observation through selective introduction of cap layers - i.e. an ultra-thin (sub nanometer) dielectric deposited in between host dielectric and gate electrode - or alternative dielectric stacks. The new dielectrics that have been explored for use as a bulk dielectric or cap layer are combinations of scandium, dysprosium, lanthanum, aluminum, and hafnium.

Results indicate that Al can be used to shift the threshold voltage upwards (of interest for PMOS), as opposed to rare earth elements that were found to shift the threshold voltage to lower values (of interest for NMOS).

Dy-based oxides show unexpectedly good results when implemented as cap layers. Figure 7 presents the threshold voltage shift for Dy-based and Sc-based oxides and a combination thereof. The magnitude of the effect is the result of a complex equation with for example the composition of the gate dielectric and metal gate as input parameters.

Further an example is given on how the parameters can be controlled in order to obtain the targeted EOT and Vt.

The SiO₂ thickness can be controlled through thermal oxidation of the substrate prior to any high-k deposition.

The various nanometer thick high-k dielectric films can be deposited by a range of techniques - preferably chemical vapor deposition like, either as nanolaminates or as co-deposited films. The composition of the film can be controlled. The thickness of SiO₂ and composition/thickness of the high-k films ought to be selected such that after application of a thermal budget, a suitable EOT is obtained.

As a demonstration, a SiON dielectric film of thickness 2nm has been capped by 1nm of Dy₂O₃ and capped with a TaN metal electrode as shown in Figure 8 (a). After application of a junction activation thermal budget (1030°C), a gate stack EOT has been extracted, clearly less than the original 2nm SiON. A reduction in EOT from ~1.8nm down to 1.3nm EOT has been observed, as well as a reduction in Vt as shown in Figure 8 (b). Also, a similar experiment has been done using HfSiON dielectrics with Dy₂O₃ cap.

## Claims

1. A method for forming a gate stack in a MOSFET device, comprising the steps of:
- forming, on a semiconductor substrate (1), at least one layer of a dielectric material (2, 2a), the upper layer comprising a Si containing dielectric material (Si-CDM),
- depositing on said Si-CDM, at least one rare earth oxide (REO) layer (4),
- depositing on said REO layer (4), at least one layer of a suitable material for forming a metal gate electrode (5), and
- after having deposited said material suitable for forming a metal gate electrode on said REO layer, annealing, whereby a rare earth silicate (RES) layer is formed,
wherein there is no annealing step before having deposited said material suitable for forming a metal gate electrode on said REO layer.

2. A method according to claim 1, wherein said REO and said Si-CDM are provided in a ratio REO: (REO + Si(CDM)) comprised between 0.1 and 0.4.

3. A method according to claim 1, wherein said REO and said Si-CDM are provided in a ratio REO: (REO + Si(CDM)) comprised between 0.2 and 0.3.

4. A method according to any of claims 1 to 3, wherein said at least one REO layer is formed or deposited by MOCVD, ALD, AVD or PVD deposition technique.

5. A method according to any of claims 1 to 4, wherein said REO layer (4) comprises any of La, Y, Pr, Nd, Sm, Eu, Gd, Dy, Er, or Yb, or any combination of 2, 3 or more thereof, more particularly any of La, Y, Pr, Nd, Sm, Eu, Gd, Dy, Er, or Yb based oxides, or any combination of 2, 3 or more thereof.

6. A method according to claim 5, wherein said REO layer (4) comprises any of La and/or Dy based oxides.

7. A method according to any of claims 1 to 6, wherein said REO layer (4) comprises dysprosium oxide.

8. A method according to any of claims 1 to 6, wherein said REO layer (4) comprises dysprosium scandate.

9. A method according to any of claims 1 to 8, wherein said REO layer (4) further comprises Sc, Hf or Al.

10. A method for forming a gate stack in a MOSFET device, comprising the steps of:
- forming, on a semiconductor substrate, at least one layer of a dielectric material, the upper layer comprising a Si containing dielectric material (Si-CDM),
- depositing on said Si-CDM, at least one rare earth (RE) layer,
- depositing on said RE layer, at least one layer of a suitable material for forming a metal gate electrode, and
- after having deposited said material suitable for forming a metal gate electrode on said RE layer, annealing, whereby a rare earth silicate (RES) layer is formed,
wherein oxidation of said RE layer is prevented, and
wherein there is no annealing step before having deposited said material suitable for forming a metal gate electrode on said RE layer.

11. A method according to any of claims 1 to 10, wherein said layer of Si-CDM comprises any suitable high-k material (i.e. k > k_{SiO2}).

12. A method according to any of claims 1 to 11, wherein said layer of Si-CDM comprises SiO₂.

13. A method according to any of claims 1 to 11, wherein said layer of Si-CDM consists of SiO₂.

14. A method according to any of claims 1 to 13, wherein said layer of Si-CDM comprises or further comprises nitrogen.

15. A method according to claim 14, wherein said layer of Si-CDM consists of SiON.

16. A method according to any of claims 1 to 15, wherein said annealing step is performed at a temperature higher than 600°C, preferably comprised between 600°C and 1200°C, more preferably comprised between 600°C and 1000°C.

17. A method according to any of claims 1 to 15, wherein said annealing step is performed at a temperature higher than 800°C, preferably comprised between 800°C and 1200°C, more preferably comprised between 800°C and 1000°C.

18. A method according to any of claims 1 to 17, wherein said Si-CDM is formed or deposited by MOCVD, ALD, AVD or PVD deposition technique.

19. A method according to any of claims 1 to 18, wherein said metal gate electrode (5) comprises W, Ta, TI, Ru, Pt and/or Mo, preferably TiN, TaN and/or Ru.

20. A method according to any of claims 1 to 19, wherein said substrate (1) comprises a Ge, SiGe, GaAs, and/or InP layer.

21. A method according to any of claims 1 to 20, wherein said annealing step is a post-deposition anneal.

22. A method according to any of claims 1 to 20, wherein said annealing step is a Rapid Thermal Anneal.

23. A MOSFET device obtainable by a method according to any of claims 1 to 22.

24. A MOSFET device according to claim 23 comprising:
- a semiconductor substrate (1),
- a gate dielectric comprising at least one layer of a dielectric material, the upper layer comprising (or consisting of) a Si containing dielectric material (Si-CDM) (2a),
- upon said Si-CDM (2a), a rare earth silicate (RES) layer (3), and
- upon said RES layer (3), a metal gate electrode (5),
wherein said RES layer (3) results from the annealing of said Si-CDM and said REO or RE layer, said annealing being performed only after having deposited said metal gate electrode.

25. A MOSFET device according to claim 23 or 24, further comprising an unreacted REO layer (4a) or unreacted RE layer.

26. A MOSFET device according to any of claims 23 to 25, further comprising a polySi layer (6) on said metal gate electrode (5).

27. A MOSFET device according to any of claims 23 to 26, wherein said layer of Si-CDM comprises SiO₂, SiON, HfSiO, or HfSiON.

28. A MOSFET device according to any of claims 23 to 27, wherein said REO or RE layer comprises any of La, Y, Pr, Nd, Sm, Eu, Gd, Dy, Er, Yb or any combination of 2, 3 or more thereof.

29. A MOSFET device according to any of claims 23 to 27, wherein said REO layer comprises any of La-, Y-, Pr-, Nd-, Sm-, Eu-, Gd-, Dy-, Er-, and Yb- based oxides or any combination of 2, 3 or more thereof.

30. A MOSFET device according to any of claims 23 to 27, wherein said REO layer comprises any of La and/or Dy based oxides.

31. A MOSFET device according to any of claims 23 to 27, wherein said REO layer comprises dysprosium oxide, or dysprosium scandate.

32. A MOSFET device according to any of claims 23 to 31, wherein said metal gate electrode comprises W, Ti, Ta, Pt, Ru and/or Mo, preferably TiN, TaN and/or Ru.

33. A MOSFET device according to any of claims 23 to 32, wherein said substrate (1) comprises a Ge, SiGe, GaAs, and/or InP layer.

34. A method for forming a capacitor, such as a metal-insulator-metal capacitor, comprising the steps of:
- forming, on a material suitable for forming an electrode, at least one layer comprising a Si-CDM,
- depositing on said Si-CDM, at least one REO or RE layer,
- depositing on said REO or RE layer, at least one layer of a material suitable for forming an electrode, and
- after having deposited said material suitable for forming an electrode on said REO or RE layer, annealing, whereby a RES layer is formed,
wherein there is no annealing step before having deposited said material suitable for forming an electrode on said REO or RE layer.

35. A capacitor, such as a metal-insulator-metal capacitor, obtainable by a method according to claim 34.
